# EUROPEAN PATENT APPLICATION

(11) **EP 4 550 946 A1**
(43) Date of publication of application: **07.05.2025**
(21) Application number: 24790813.0
(22) Date of filing: 19.09.2024
(51) Int. Cl.: H05K 1/02, H05K 1/11, H04M 1/02, H05K 1/14

(54) **MULTILAYERED FLEXIBLE PRINTED CIRCUIT BOARD AND ELECTRONIC DEVICE COMPRISING SAME**

(30) Priority: 19.09.2023 KR 20230124780; 04.01.2024 KR 20240001750
(71) Applicant: Samsung Electronics Co., Ltd, Suwon-si, Gyeonggi-do 16677 (KR)
(72) Inventor: SEONG, Younghun, Suwon-si, Gyeonggi-do 16677 (KR)
(74) Representative: Appleyard Lees IP LLP
(86) International application number: PCT/KR2024/096206
(87) International publication number: WO 2025/063829

(57) **Abstract**

A flexible printed circuit board, and an electronic device are provided. The flexible printed circuit board includes a first layer including at least one RF conductive wire for transmitting a radio frequency signal, a second layer spaced apart from the first layer by a first distance in a first direction perpendicular to a surface of the flexible printed circuit board and including a second ground conductor, a third layer spaced apart from the first layer by a second distance, which is longer than the first distance, in a direction opposite to the first direction and including a third ground conductor, and at least one fourth layer positioned between the first layer and the third layer.

## Description

### [Technical Field]

The disclosure relates to a flexible printed circuit board and an electronic device comprising the same.

### [Background Art]

Electronic devices may include wires for connecting electrical components to each other. Flexible printed circuits boards may include wires formed on a substrate layer by patterning a conductive layer. Such wires are typically thin compared to other types of cables or rigid printed circuit boards, so can be used to reduce the sizes of the electronic devices. The flexible printed circuit boards, including those with wires formed thereon may transmit power and/or signals (e.g., digital signals, analog signals, and/or radio frequency, "RF" signals).

### [Disclosure of Invention]

### [Solution to Problem]

When a high-frequency signal is transmitted through a flexible printed circuit board, signal quality may deteriorate due to the action of various parasitic effects (e.g., parasitic capacitance) of the flexible printed circuit board. In addition, when the flexible printed circuit board is incorporated in an electronic device with other electrical components, electromagnetic interference, "EMI", generated by high-frequency currents may cause problems with the other electrical components , and the EMI generated by the other electrical components may cause distortion and/or errors in signals transmitted through the flexible printed circuit board.

To prevent distortion and/or errors, ground conductors for shielding against EMI may be disposed on the periphery of a signal transmission wire (trace) of the flexible printed circuit board. However, when the ground conductors located in different layers of the flexible printed circuit board are connected to each other through vias to shield the entire periphery of the signal transmission wire (trace), the layers through which the vias pass need to be tightly attached to each other. The requirement for tight attachment of the layers can be addressed by increasing the thickness and rigidity of the flexible printed circuit board. Thus, the above-described shielding means may increase the size of the electronic device. In addition, the effectiveness of the shielding may be limited in electronic devices with variable form factors, such as foldable, slidable, or rollable electronic devices. Furthermore, ground conductors disposed for shielding EMI may cause parasitic capacitance to be changed according to the change in distance from the signal transmission wire (trace) when the flexible printed circuit board is deformed by bending, and thus may increase signal loss.

Embodiments of the disclosure may provide a flexible printed circuit board having reduced thickness, which provides effective shielding of electromagnetic interference, and having improved flexibility.

An electronic devices may include a housing and a flexible printed circuit board positioned inside the housing and configured to transmit a RF signal, wherein the flexible printed circuit board may include a first layer including a first ground conductor and at least one RF conductive wire for transmitting the RF signal, a second layer spaced apart from the first layer by a first distance in a first direction perpendicular to one surface of the flexible printed circuit board and including a second ground conductor, a third layer spaced apart from the first layer by a second distance, which is longer than the first distance, in a second direction opposite to the first direction and including a third ground conductor, and a fourth layer positioned between the first layer and the third layer.

A flexible printed circuit board may include a first layer including a first ground conductor and at least one RF conductive wire for transmitting a RF signal, a second layer spaced apart from the first layer by a first distance in a first direction perpendicular to one surface of the flexible printed circuit board and including a second ground conductor, a third layer spaced apart from the first layer by a second distance, which is longer than the first distance, in a second direction opposite to the first direction and including a third ground conductor, and a fourth layer positioned between the first layer and the third layer.

Embodiments of the disclosure may provide a flexible printed circuit board including some layers not being attached to each other, and thus having reduced thickness and improved flexibility. In addition, signal loss due to capacitance variation generated by a third ground conductor may be reduced by spacing the third ground conductor relatively further away from the RF conductive wire than a second ground conductor.

### [Brief Description of Drawings]

In relation to the description of the drawings, identical or similar reference numerals may be used for identical or similar components.
FIG. 1 is a block diagram of an electronic device in a network environment.
FIGS. 2A, 2B, 2C, 2D, and 2E illustrate an electronic device.
FIG. 3 illustrates an electronic device.
FIG. 4a illustrates a perspective view showing a flexible printed circuit board.
FIG. 4b illustrates a plan view showing a flexible printed circuit board.
FIG. 5 is a cross-sectional view of a flexible printed circuit board.
FIG. 6 is a cross-sectional view of a flexible printed circuit board.
FIG. 7 is a plan view of a flexible printed circuit board.
FIG. 8A is a cross-sectional view showing the flexible printed circuit board.
FIG. 8B is a cross-sectional view showing the second region of the flexible printed circuit board.
FIG. 9 is a schematic diagram showing the interior of an electronic device.

### [Mode for the Invention]

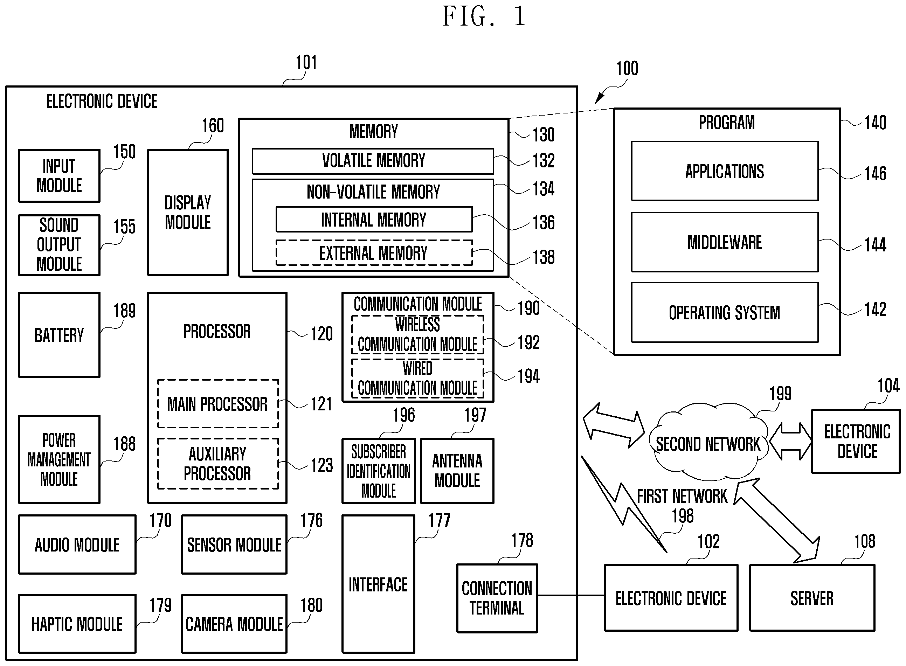

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly, i.e. through a wired connection) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large-scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adj acent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another and does not limit the components in other aspect (e.g., importance or order). It is to be understood that if an element (e.g., a first element) is referred to, with or without the term "operatively" or "communicatively", as "coupled with," "coupled to, " "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

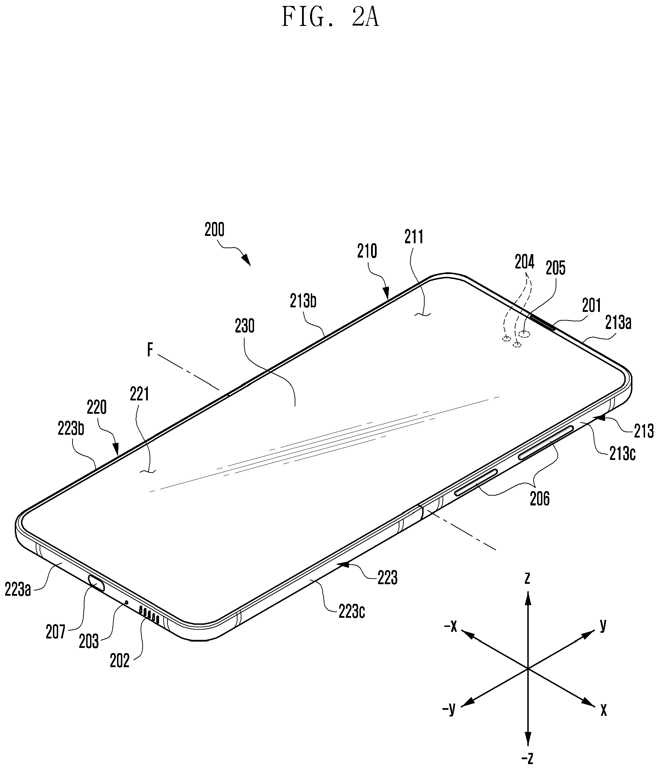

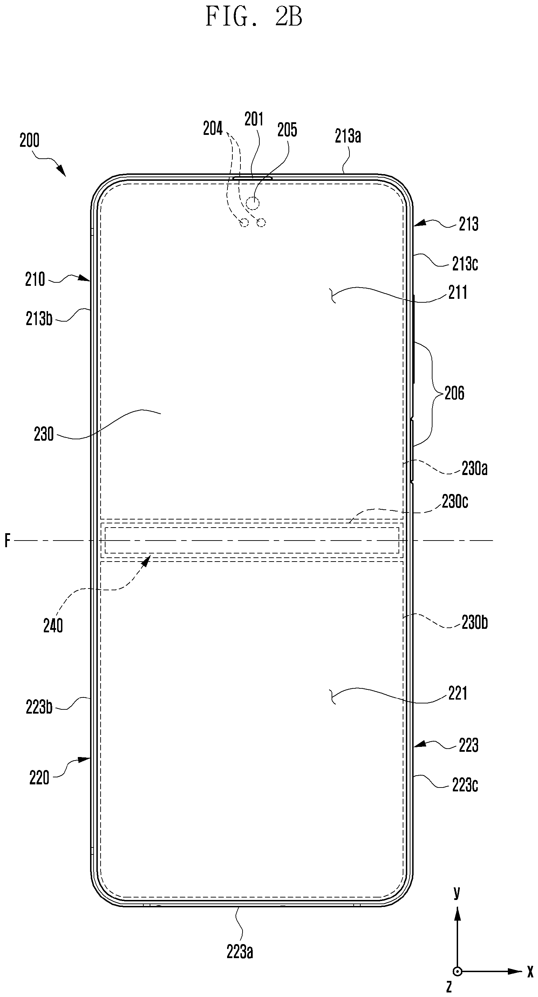

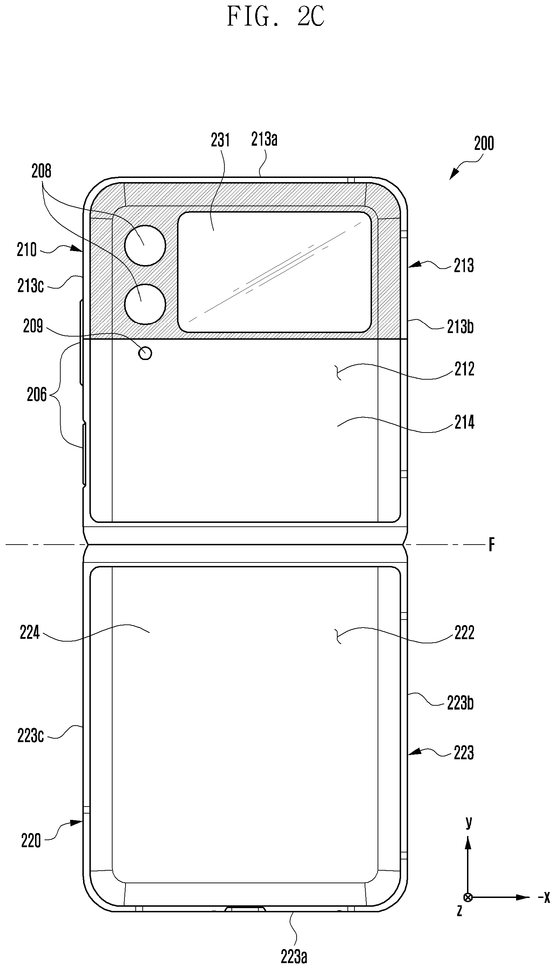

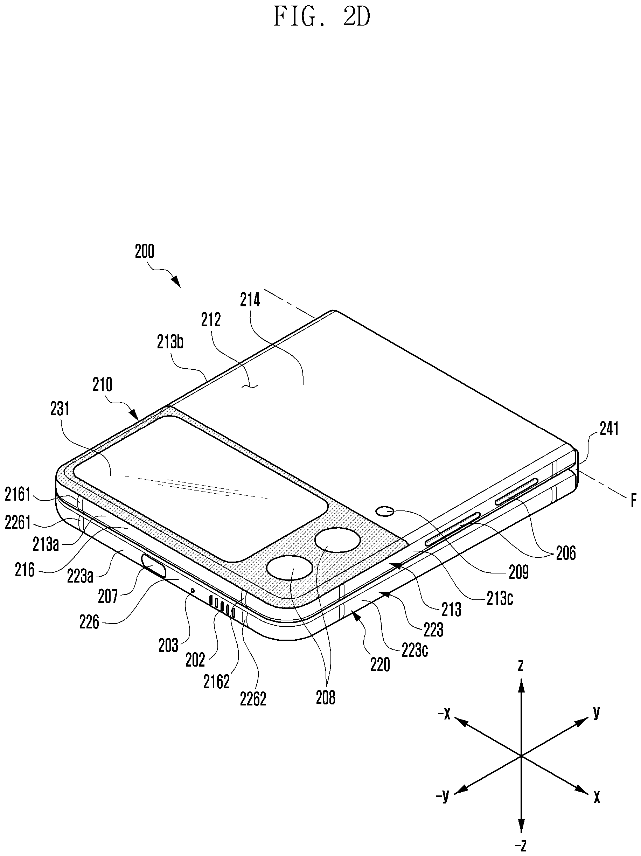

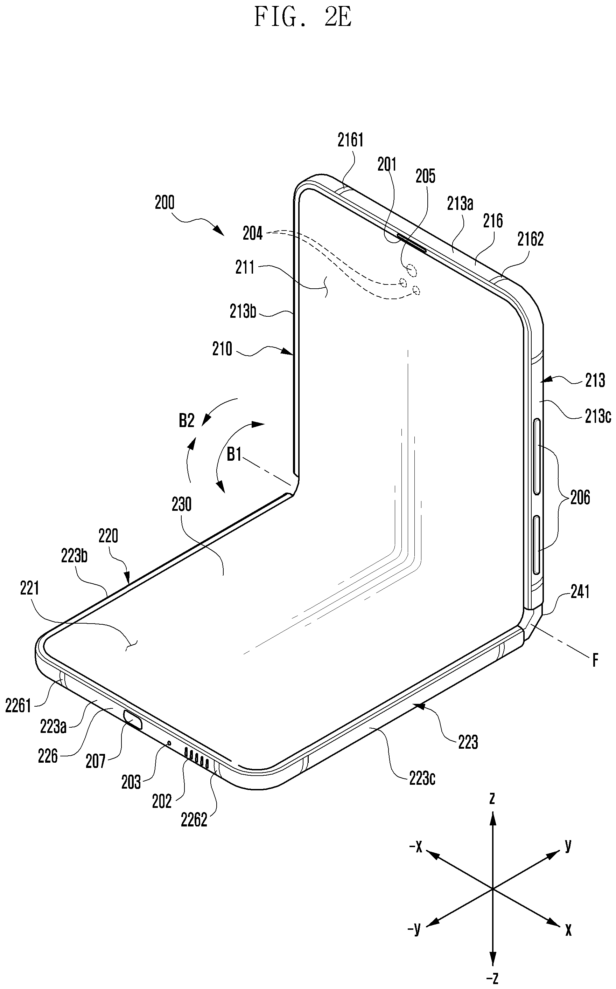

FIGS. 2A, 2B, 2C, 2D, and 2E illustrate an electronic device 200 according to various embodiments of the present disclosure.

FIG. 2A is a perspective view of an electronic device illustrating a flat state or unfolded state of the electronic device according to various embodiments of the disclosure. FIG. 2B is a plan view illustrating the front of the electronic device in an unfolded state according to an embodiment of the disclosure. FIG. 2C is a plan view illustrating the rear of the electronic device in an unfolded state according to an embodiment of the disclosure. FIG. 2D is a perspective view of an electronic device illustrating a folded state of the electronic device according to an embodiment of the disclosure. FIG. 2E is a perspective view of an electronic device illustrating an intermediate state of the electronic device according to an embodiment of the present disclosure.

Referring to FIGS. 2A to 2E, the electronic device 200 may include first and second housings 210 and 220 that are foldably coupled to each other on the basis of a hinge device (e.g., the hinge device 240 of FIG. 2B) (e.g. a foldable housing structure). In an embodiment, the hinge device (e.g., the hinge device 240 of FIG. 2B) may be arranged in the X-axis direction or in the Y-axis direction. In an embodiment, the electronic device 200 may include a first display 230 (e.g., a flexible display, a foldable display or a main display) disposed in a region (e.g., a recess) formed by the first and second housings 210 and 220. In an embodiment, the first housing 210 and the second housing 220 may be disposed on both sides of the folding axis (F) and may have a shape that is substantially symmetrical with respect to the folding axis (F). In an embodiment, the angle or distance between the first housing 210 and the second housing 220 may vary depending on the state of the electronic device 200. For example, the angle or distance between the first housing 210 and the second housing 220 may vary depending on whether the electronic device is in a flat state or unfolded state, a folded state, or an intermediate state.

In an embodiment, when the electronic device 200 is unfolded, the first housing 210 may include a first surface 211 facing in a first direction (e.g., the front direction) (the z-axis direction) and a second surface 212 facing a second direction (e.g., the rear direction) (the -z axis direction) opposite to the first surface 211. In an embodiment, when the electronic device 200 is unfolded, the second housing 220 may include a third surface 221 facing the first direction (the z-axis direction) and a fourth surface 222 facing a second direction (the -z-axis direction). In an embodiment, when the electronic device 200 is unfolded, the first surface 211 of the first housing 210 and the third surface 221 of the second housing 220 may be aligned in substantially the same first direction (the z-axis direction). In an embodiment, when the electronic device 200 is folded, the first surface 211 of the first housing 210 and the third surface 221 of the second housing 220 may face each other. In an embodiment, when the electronic device 200 is unfolded, the second surface 212 of the first housing 210 and the fourth surface 222 of the second housing 220 may be aligned in substantially the same second direction (the -z-axis direction). In an embodiment, when the electronic device 200 is in a folded state, the second surface 212 of the first housing and the fourth surface 222 of the second housing 220 may face in opposite directions. For example, when the electronic device 200 is folded, the second surface 212 may face the first direction (the z-axis direction), and the fourth surface 222 may face the second direction (the -z-axis direction). In this case, the first display 230 may not be visible from the outside (in folding-type). In an embodiment, the electronic device 200 may be folded such that the second surface 212 of the first housing 210 and the fourth surface 222 of the second housing 220 face each other. In this case, the first display 230 may be arranged to be visible from the outside (out folding-type).

According to an embodiment, the first housing 210 (e.g., a first housing structure) may include a first lateral member 213 that at least partially forms the exterior of the electronic device 200, and a first rear cover 214 that is coupled to the first lateral member 213 and at least partially forms the second surface 212 of the electronic device 200. In an embodiment, the first lateral member 213 may include a first lateral surface 213a, a second lateral surface 213b extending from one end of the first lateral surface 213a, and a third lateral surface 213c extending from the other end of the first lateral surface 213a. In an embodiment, the first lateral member 213 may be formed into a rectangular (e.g., square or rectangular) shape through the first lateral surface 213a, the second lateral surface 213b, and the third lateral surface 213c.

According to an embodiment, the second housing 220 (e.g., a second housing structure) may include a second lateral member 223 that at least partially forms the exterior of the electronic device 200, and a second rear cover 224 that is coupled to the second lateral member 223 and at least partially forms the fourth surface 222 of the electronic device 200. In an embodiment, the second lateral member 223 may include a fourth lateral surface 223a, a fifth lateral surface 223b extending from one end of the fourth lateral surface 223a, and a sixth lateral surface 223c extending from the other end of the fourth lateral surface 223a. In an embodiment, the second lateral member 223 may be formed into a rectangular shape through the fourth lateral surface 223a, the fifth lateral surface 223b, and the sixth lateral surface 223c.

According to an embodiment, the first and second housings 210 and 220 are not limited to the illustrated shapes and combinations, and may be implemented in other shapes or implemented by combining and/or connecting parts. In an embodiment, the first lateral member 213 may be formed integrally with the first rear cover 214, and the second lateral member 223 may be formed integrally with the second rear cover 224.

According to an embodiment, when the electronic device 200 is unfolded, the second lateral surface 213b of the first lateral member 213 and the fifth lateral surface 223b of the second lateral member 223 may be connected to each other without a gap therebetween. In an embodiment, when the electronic device 200 is unfolded, the third lateral surface 213c of the first lateral member 213 and the sixth lateral surface 223c of the second lateral member 223 may be connected to each other without a gap therebetween. In an embodiment, when the electronic device 200 is unfolded, the sum of the length of the second lateral surface 213b and the length of the fifth lateral surface 223b may be configured to be longer than the length of the first lateral surface 213a and/or the fourth lateral surface 223a. In an embodiment, when the electronic device 200 is unfolded, the sum of the length of the third lateral surface 213c and the length of the sixth lateral surface 223c may be configured to be longer than the length of the first lateral surface 213a and/or the fourth lateral surface 223a.

Referring to FIGS. 2D and 2E, the first lateral member 213 and/or the second lateral member 223 may be formed of metal or may further include a polymer injected into the metal. In an embodiment, the first lateral member 213 and/or the second lateral member 223 may include at least one conductive part 216 and/or 226 electrically segmented through at least one segment part 2161, 2162 and/or 2261, 2262 formed of a polymer. In this case, the at least one conductive part 216 and/or 226 may be electrically connected to the wireless communication circuit included in the electronic device 200 to be used as at least a part of an antenna operating in at least one designated band (e.g., legacy band).

According to an embodiment, the first rear cover 214 and/or the second rear cover 224 may be, for example, formed of at least one of coated or colored glass, ceramic, polymer, or metal (e.g., aluminum, stainless steel (STS), or magnesium) or a combination of at least two thereof.

According to an embodiment, the first display 230 may be arranged to extend to at least a part of the third surface 221 of the second housing 220 from the first surface 211 of the first housing 210 across a hinge device (e.g., the hinge device 240 of FIG. 2B). In an embodiment, the first display 230 may include a first region 230a substantially corresponding to the first surface 211, a second region 230b corresponding to the second surface 212, and a third region 230c (e.g., a bendable region or a folding region) connecting the first region 230a and the second region 230b. In an embodiment, the third region 230c is part of the first region 230a and/or the second region 230b and may be located at a position corresponding to the hinge device (e.g., the hinge device 240 of FIG. 2B). In an embodiment, the electronic device 200 may include a hinge housing 241 (e.g., a hinge cover) configured to support the hinge device (e.g., the hinge device 240 of FIG. 2B). In an embodiment, when the electronic device 200 is folded, the hinge housing 241 may be exposed to the outside, and when the electronic device 200 is unfolded, the hinge housing 241 may be inserted into the inner space of the first housing 210 and the inner space of the second housing 220 and thus be invisible from the outside.

According to an embodiment, the electronic device 200 may include a second display 231 (e.g., sub-display) disposed separately from the first display 230. In an embodiment, the second display 231 may be disposed to be at least partially exposed on the second surface 212 of the first housing 210. In an embodiment, when the electronic device 200 is folded, the second display 231 may replace at least part of the display function of the first display 230 to display at least part of the status information of the electronic device 200. In an embodiment, the second display 231 may be arranged to be visible from the outside through at least a partial region of the first rear cover 214. In an embodiment, the second display 231 may be disposed on the fourth surface 222 of the second housing 220. In this case, the second display 231 may be arranged to be visible from the outside through at least a partial region of the second rear cover 224.

According to an embodiment, the electronic device 200 may include at least one of an input device 203 (e.g., a microphone), an audio output device 201 or 202, a sensor module 204, a camera device 205 or 208, a key input device 206, or a connector port 207. In the illustrated embodiment, the input device 203 (e.g., a microphone), the audio output device 201 or 202, the sensor module 204, the camera device 205 or 208, the key input device 206, or the connector port 207 is shown as a hole or circle-shaped element disposed in the first housing 210 or the second housing 220, but is an exemplarily illustrated for explanation and is not limited thereto. According to an embodiment, the input device 203 may include at least one microphone 203 disposed in the second housing 220. In an embodiment, the input device 203 may include a plurality of microphones 203 arranged to detect the direction of sound. In an embodiment, the plurality of microphones 203 may be placed at appropriate positions in the first housing 210 and/or the second housing 220. In an embodiment, the sound output device 201 or 202 may include at least one speaker 201 or 202. In an embodiment, the at least one speaker 201 or 202 may include a call receiver 201 disposed in the first housing 210 and the speaker 202 disposed in the second housing 220. In an embodiment, the input device 203, the audio output device 201 or 202, and the connector port 207 may be positioned in a space provided in the first housing 210 and/or the second housing 220 of the electronic device 200 and may be exposed to the external environment through at least one hole disposed in the first housing 210 and/or the second housing 220. In an embodiment, at least one connector port 207 may be used to transmit and receive power and/or data to and from an external electronic device. In an embodiment, at least one connector port (e.g., ear jack hole) may accommodate a connector (e.g., ear jack) for transmitting and receiving audio signals to and from the external electronic device. In an embodiment, the hole disposed in the first housing 210 and/or the second housing 220 may be commonly used for the input device 203 and the audio output device 201 or 202. In an embodiment, the sound output device 201 or 202 may also include a speaker (e.g., a piezo speaker) that is not exposed through a hole disposed in the first housing 210 and/or the second housing 220.

According to an embodiment, the sensor module 204 may generate an electrical signal or data value corresponding to the internal operating state or the external environmental state of the electronic device 200. In an embodiment, the sensor module 204 may detect the external environment through the first surface 211 of the first housing 210. In an embodiment, the electronic device 200 may further include at least one sensor module disposed to detect the external environment through the second surface 212 of the first housing 210. In an embodiment, the sensor module 204 (e.g., an illumination sensor) may be disposed below the first display 230 to detect the external environment through the first display 230. In an embodiment, the sensor module 204 may include at least one of a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, an illumination sensor, a proximity sensor, a biometric sensor, an ultrasonic sensor, or an illumination sensor 204.

According to an embodiment, the camera device 205 or 208 may include a first camera device 205 (e.g., a front camera device) disposed on the first surface 211 of the first housing 210, and a second camera device 208 disposed on the second surface 212 of the second housing 210. In an embodiment, the electronic device 200 may further include a flash 209 disposed near the second camera device 208. In an embodiment, the camera device 205 or 208 may include at least one lens, image sensor, and/or image signal processor. In an embodiment, the camera device 205 or 208 may include two or more lenses (e.g., a wide-angle lens, an ultra-wide-angle lens, or a telephoto lens) and two or more image sensors, which are disposed on one surface (e.g., the first surface 211, the second surface 212, the third surface 221, or the fourth surface 222) of the electronic device 200. In an embodiment, the camera device 205 or 208 may include time of flight (TOF) lenses and/or an image sensor.

According to an embodiment, the key input device 206 (e.g., a key button) may be disposed on the third lateral surface 213c of the first later member 213 of the first housing 210. In an embodiment, the key input device 206 may be disposed on at least one lateral surface among the different lateral surfaces 213a and 213b of the first housing 210 and/or the lateral surfaces 223a, 223b, and 223c of the second housing 220. In an embodiment, the electronic device 200 may not include some or all of the key input devices 206, and the key input devices 206 that are not included may also be implemented in a different form, such as soft keys, on the first display 230. In an embodiment, the key input device 206 may be implemented using a pressure sensor included in the first display 230.

According to one embodiment, some of the camera devices 205 and 208 (e.g., the first camera device 205) or the sensor module 204 may be arranged to be exposed through the first display 230. In an embodiment, the first camera device 205 or the sensor module 204 may be optically exposed to the outside through an opening (e.g., a through hole) at least partially disposed in the first display 230 from the inner space of the electronic device 200. In an embodiment, at least a part of the sensor module 204 may be arranged so as not to be visually exposed through the first display 230 from the inner space of the electronic device 200. Referring to FIG. 2B, the electronic device 200 may operate to maintain at least one specified folding angle in an intermediate state through the hinge device (e.g., the hinge device 240 of FIG. 2B). In this case, the electronic device 200 may control the first display 230 such that the display region corresponding to the first surface 211 and the display region corresponding to the third surface 221 display content different from each other. In an embodiment, the electronic device 200 may be operated in a substantially unfolded state (e.g., the unfolded state of FIG. 2A) and/or in a substantially folded state (e.g., the folded state of FIG. 2D), based on a certain folding angle (e.g., the angle between the first housing 210 and the second housing 220 when the electronic device 200 is in an intermediate state) through the hinge device (e.g., the hinge device 240 of FIG. 2B). In an embodiment, when a pressing force is provided in the unfolding direction (direction B1) in an unfolded state at a certain folding angle, the electronic device 200 may be operated to transition to an unfolded state (e.g., the unfolded state of FIG. 2A) through the hinge device (e.g., the hinge device 240 of FIG. 2B). In an embodiment, when a pressing force is provided in the folding direction (direction B2) in an unfolded state at a certain folding angle, the electronic device 200 may be operated to transition to a folded state (e.g., the folded state of FIG. 2D) through the hinge device (e.g., the hinge device 240 of FIG. 2B). In an embodiment, the electronic device 200 may be operated to maintain the unfolded state (not shown) at various folding angles through the hinge device (e.g., the hinge device 240 of FIG. 2B) (free stop function).

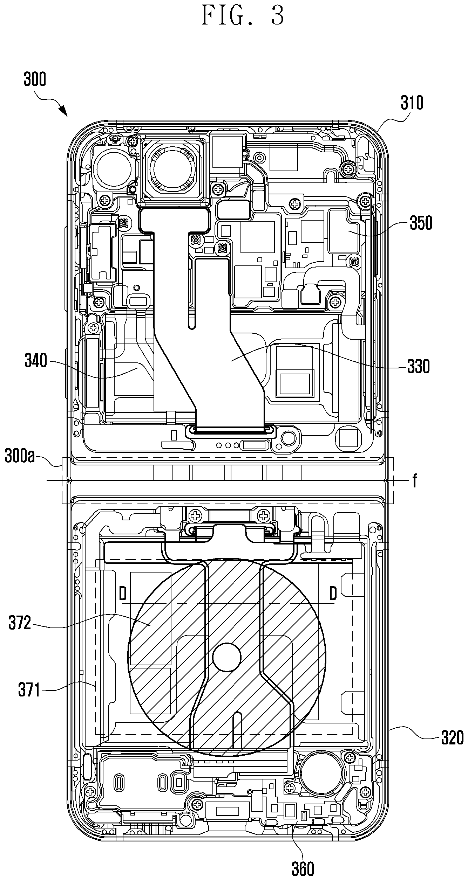

FIG. 3 illustrates an electronic device 300.

Referring to FIG. 3, the electronic device 300 may broadly correspond to e.g., the electronic device 101 of FIG. 1 and the electronic device 200 of FIG. 2A to 2E. The electronic device 300 may include a first housing 310, a second housing 320, a first flexible printed circuit board 330, a second flexible printed circuit board 340, a first printed circuit board 350, and/or a second printed circuit board 360. The electronic device 300 may be a foldable device. The first housing 310 and the second housing 320 may be foldably coupled to each other about the folding axis F.

The electronic device 300 may include a folding region 300A positioned between the first housing 310 and the second housing 320. A hinge 390 configured to allow the first housing 310 and the second housing 320 to rotate may be positioned in the folding region 300A. The first housing 310 and the second housing 320 may be rotatably connected to each other through a hinge 390.

The first printed circuit board 350 may be disposed in the first housing 310. The second printed circuit board 360 may be disposed in the second housing 320.

In various embodiments, a processor 120 (see FIG. 1) and/or a memory 130 (see FIG. 1) may be disposed on the first printed circuit board 350 and/or the second printed circuit board 360. The processor 120 (see FIG. 1) may include a main processor 121 (see FIG. 1) (e.g., a central processing unit or processor) or an auxiliary processor 123 (see FIG. 1) (e.g. a graphics processing unit, a neural processing unit (NPU), an image signal processor, a sensor hub processor, or a communication processor) operable independently or together with the main processor 121 (see FIG. 1). The memory 130 (see FIG. 1) may include volatile memory 132 (see FIG. 1) or non-volatile memory 134 (see FIG. 1).

The first flexible printed circuit board 330 may be disposed in the first housing 310 and the second housing 320. The first flexible printed circuit board 330 may extend from the first housing 310 toward the second housing 320 via the folding region 300A.

One end of the first flexible printed circuit board 330 may be connected to the first printed circuit board 350, and the other end of the first flexible printed circuit board 330 may be connected to the second printed circuit board 360. The first flexible printed circuit board 330 may electrically connect the second printed circuit board 360 to the first printed circuit board 350.

The second flexible printed circuit board 340 may be disposed in the first housing 310 and the second housing 320. The second flexible printed circuit board 340 may extend from the first housing 310 toward the second housing 320 via the folding region 300A.

One end of the second flexible printed circuit board 340 may be connected to the first printed circuit board 350, and the other end of the second flexible printed circuit board 340 may be connected to the second printed circuit board 360. The second flexible printed circuit board 340 may electrically connect the second printed circuit board 360 to the first printed circuit board 350.

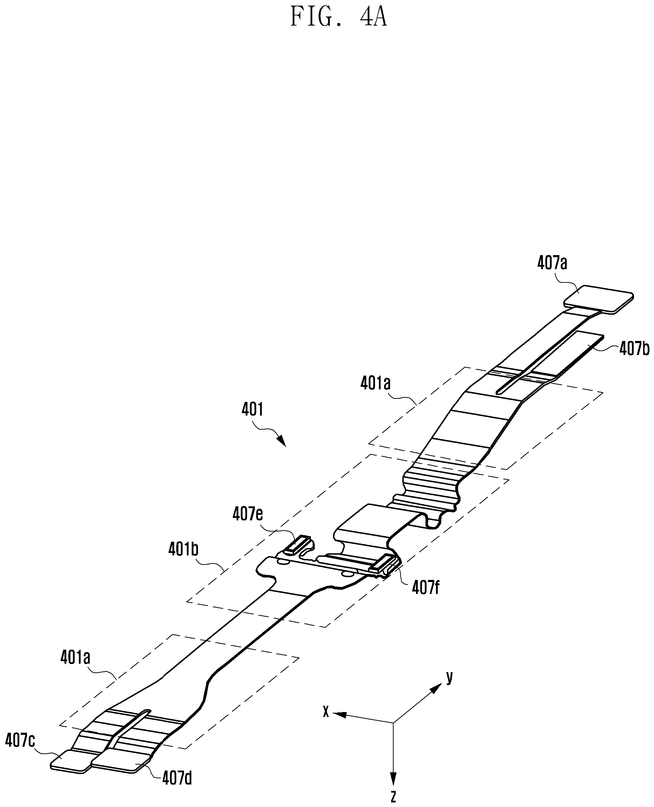

FIG. 4A is a perspective view showing a flexible printed circuit board 401.

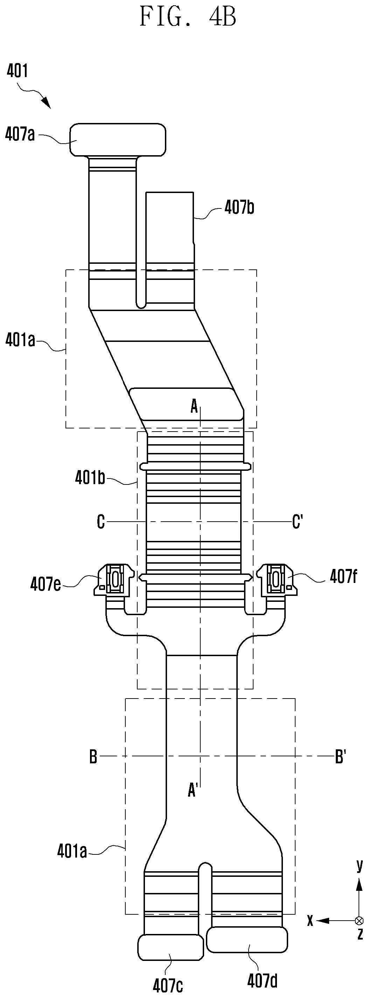

FIG. 4B is a plan view showing the flexible printed circuit board 401.

Referring to FIGS. 4A and 4B, the flexible printed circuit board 401 (e.g., the first flexible printed circuit board 330 or the second flexible printed circuit board 340 of FIG. 3) includes a first region 401a and a second region 401b. The rigidity of the first region 401a in the longitudinal direction (referred to as "first rigidity") has a relatively high value compared to the rigidity of the second region 401b in the longitudinal direction (referred to as "second rigidity"). The first region 401a may correspond to a region that is relatively less moved or bent within the electronic device (e.g., the electronic device 101 of FIG. 1, the electronic device 200 of FIGS. 2A to 2E, or the electronic device 300 of FIG. 3) and maintains a flat shape. The second region 401b has relatively lower rigidity than the first region 401a. The second region 401b may correspond to a region that is relatively or more significantly moved or bent to a curved shape when assembling the electronic device and/or using the electronic device. For example, the second region 401b may include a region of the flexible printed circuit board 401 that passes through a folding region (e.g., the folding region 300A of FIG. 3) of the electronic device.

The flexible printed circuit board 401 may include a plurality of connectors, shown as a first connector 407a, a second connector 407b, a third connector 407c, a fourth connector 407d, a fifth connector 407e, and a sixth connector 407f. The plurality of connectors may be coupled to different electrical components, for example, a printed circuit board (e.g., a first printed circuit board 350 and/or a second printed circuit board 360 of FIG. 3), a wireless communication module (e.g., the wireless communication module 192 of FIG. 1), and/or an antenna module (e.g., the antenna module 197 of FIG. 1) of the electronic device and electrically connect the same. In various embodiments, the printed circuit board may transmit various electrical interactions, such as power, digital signals, analog signals, or radio frequency (RF) signals, among the various electrical components of the electronic device 101, 200, or 300.

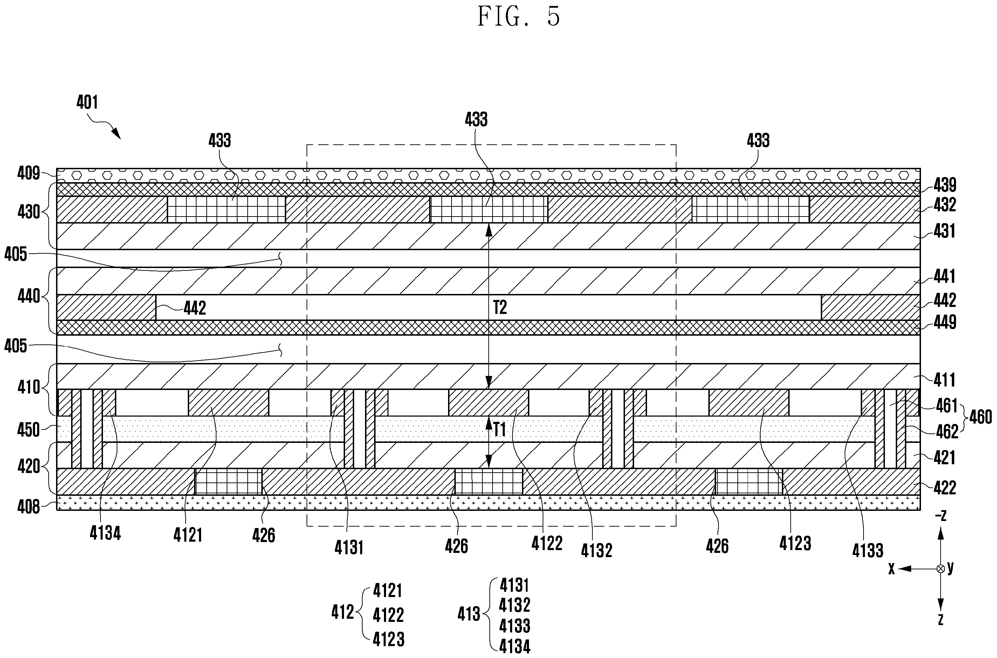

FIG. 5 is a cross-sectional view of the flexible printed circuit board 401.

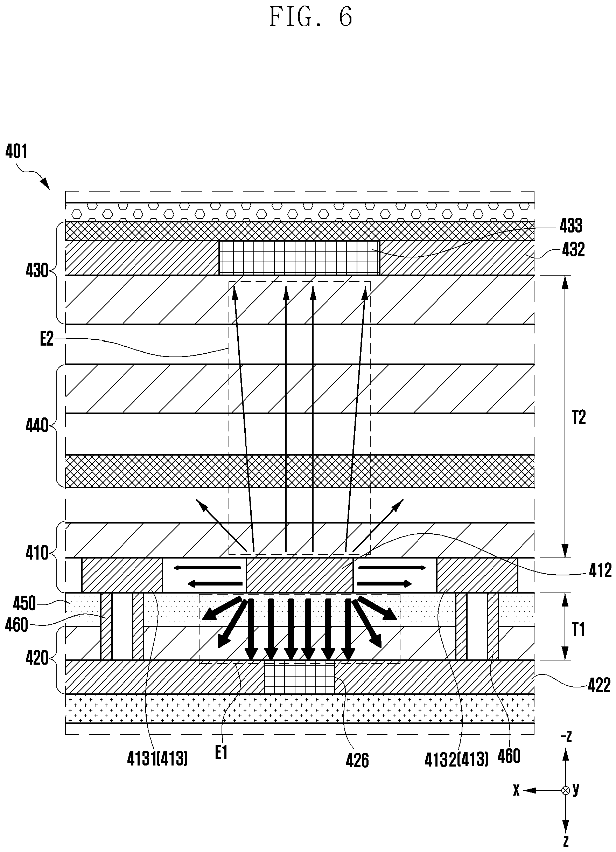

FIG. 6 is another cross-sectional view of the flexible printed circuit board 401.

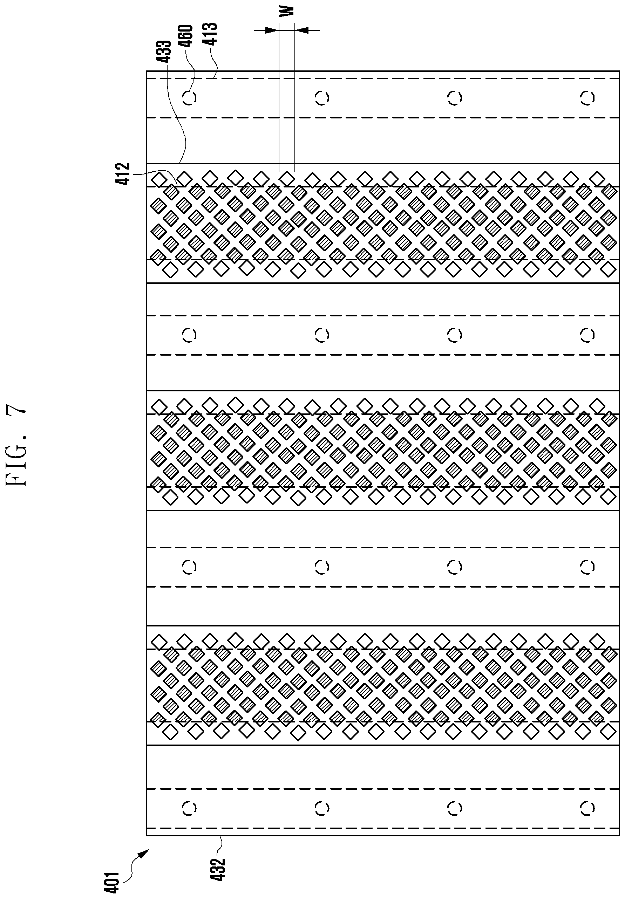

FIG. 7 is a plan view of the flexible printed circuit board 401.

FIG. 5 is a cross-sectional view of a first region 401a (cut along B-B' direction of FIG. 4B) of the flexible printed circuit board 401.

FIG. 6 is an enlarged view of region C of FIG. 5. The dimensions of each element shown in FIGS. 5 and 6 are exaggerated for convenience of explanation.

Referring to FIG. 5, the flexible printed circuit board 401 includes a plurality of layers 410, 420, 430, and 440. The flexible printed circuit board 401 includes a first layer 410, a second layer 420, a third layer 430, and a fourth layer 440. At least one of the layers may be a laminate including a substrate layer 411, 421, 431, or 441 including an insulator, and a conductor layer 412, 422, 432, or 442 cladded on the substrate layer 411, 421, 431, or 441. For example, at least one of the plurality of layers 410, 420, 430, and 440 may be a flexible copper clad laminate (FCCL) including a substrate including a polymer film, such as polyimide (PI), polyethylene terephthalate (PET), polyethylene naphthalate (PEN), liquid crystal polymer (LCP) film, aramid film, and/or fluorine-based film, and a metal foil (e.g. copper foil) cladded on the substrate. In addition, the conductor layer 412, 422, 432, or 442 may be a layer formed by patterning a metal foil cladded on FCCL using a patterning method such as lithography. In various embodiments, one of the plurality of layers 410, 420, 430, and 440 may not include a conductor layer. In various embodiments, some (e.g., the first layer 410, the third layer 430, and the fourth layer 440) of the plurality of layers 410, 420, 430, and 440 may include a coverlay 419, 439, or 449 disposed on the conductor layer 412, 422, 432, or 442. In various embodiments, a photo solder resist (PSR) paint layer 408 and/or an insulation coating layer 409 may be disposed on the surface (e.g., the bottom surface of the second layer 420 and/or the top surface of the third layer 430) of the outermost layer of the flexible printed circuit board 401.

The first layer 410 as shown is a layer through which high-frequency signals such as radio frequency (RF) signals are transmitted. The first layer 410 includes a RF conductive wire 412. The RF conductive wire 412 may be a patterned conductor that transmits high-frequency current, such as a radio frequency (RF) signal. In various embodiments, the RF conductive wire 412 of the first layer is provided as a plurality of RF conductive wires or RF conductive wire elements (e.g., a first RF conductive wire 4121, a second RF conductive wire 4122, and/or a third RF conductive wire 4123).

The first layer 410 as shown includes a first ground conductor 413. In various embodiments, the first ground conductor 413 may include a first ground trace 4131, a second ground trace 4132, a first ground trace 4133, and/or a first ground trace 4134. The first ground conductor 413 may be disposed in parallel (e.g., substantially parallel) with the RF conductive wire 412. In various embodiments, the first ground conductor 413 may be alternately disposed with each RF conductive wire 412 between a plurality of RF conductive wires 4121, 4122, 4123, and 4124. For example, a first ground trace 4131 may be disposed between the first RF conductive wire 4121 and the second RF conductive wire 4122. In addition, a second ground trace 4132 may be disposed between the second RF conductive wire 4122 and the third RF conductive wire 4123. Furthermore, in another view, the first RF conductive wire 4121 may be disposed between the fourth ground trace 4134 and the first ground trace 4131, the second RF conductive wire 4122 may be disposed between the first ground trace 4131 and the second ground trace 4132, and the third RF conductive wire 4123 may be disposed between the second ground trace 4132 and the third ground trace 4133.

The second layer 420 is positioned in a first direction (e.g., as shown in FIG. 5 and 6, the downward, the z-direction) with respect to the first layer 410, and may be a layer that shields the RF conductive wire 412 of the first layer 410 with respect to the first direction, and the second layer 420 may include the second ground conductor 422. The second ground conductor 422 may be electrically connected to the ground electrode of the electronic device. The second ground conductor 422 may be disposed on the entire surface or a partial surface of the second layer 420. The second layer 420 may be spaced apart from the first layer 410 by a first distance (T1). For example, the first distance (T1) may be the distance between the RF conductive wire 412 of the first layer 410 and the second ground conductor 422 of the second layer 420.

An adhesive layer 450 is shown in FIG. 5 and 6 disposed between the first layer 410 and the second layer 420. The adhesive layer 450 adheres the first layer 410 and the second layer 420 to each other. The adhesive layer 450 may include a curable resin, such as epoxy resin, acrylic resin, and/or phenolic resin. The adhesive layer 450 may reinforce the rigidity of the flexible printed circuit board 401. In addition, the adhesive layer 450 fastens the first layer 410 and the second layer 420 to each other such that a via 460, which will be described later, may be formed.

In various embodiments, the second ground conductor 422 may include a mesh (e.g., a first mesh conductor 426). In various embodiments, the mesh may be disposed in a partial region of the second ground conductor 422. For example, the first mesh conductor 426 may be disposed in the region of the second ground conductor 422 that at least partially overlaps the RF conductive wire 412 when viewed in the thickness direction (e.g., the z-direction or the -z-direction) of the flexible printed circuit board 401. Due to the part of the second ground conductor 422, formed as a mesh, the capacitance between the RF conductive wire 412 and the second ground conductor 422 may be adjusted by the spacing and area of the mesh. In this way, design for impedance matching of the flexible printed circuit board 401 is facilitated.

The flexible printed circuit board 401 may include the via 460 connecting the first layer 410 and the second layer 420. Examples of a via 460 are shown in FIG. 5, 6 and 7. The via 460 may be positioned on the side (e.g., the y-direction and the -y-direction) of each RF conductive wire 412 of the first layer 410. For example, the via 460 may include a via hole 461 formed through to connect first ground conductor 413 disposed on the side (e.g., the y direction and the -y direction) of each RF conductive wire 412 of the first layer 410 to the second ground conductor 422 of the second layer 420, and a via plating layer 462 disposed inside the via hole 461 by electrolytic plating and/or chemical plating and in contact with the first ground conductor 413 and the second ground conductor 422 to be electrically connected thereto. The via 460 may be grounded through the second ground conductor 422 to shield the RF conductive wire 412 from the side (e.g., the y-direction and the -y-direction). In some embodiments, the interior of the via hole 461 may be filled with filler. In another embodiment, the via 460 may be an open via 460 obtained when the via hole 461 is not completely filled. In various embodiments, the via 460 may be in electrical contact with a region of second ground conductor 422.

A third layer 430 is shown in FIG. 5 and 6, positioned in a second direction (e.g., upward, the -z direction) opposite to the first direction with respect to the first layer 410, and electrically shielding the RF conductive wire 412 of the first layer 410 with the second direction. For example, the third layer 430 may include a third ground conductor 432 disposed to overlap the RF conductive wire 412 when viewed in a vertical direction (e.g., the z-direction). The third ground conductor 432 may include a second mesh conductor 433. The second mesh conductor 433 may be a region of the third ground conductor 432 that is patterned to have a mesh shape.

The third layer 430 may be spaced apart from the first layer 410 by a second distance (T2) in the second direction. For example, the second distance (T2) may be the distance between the RF conductive wire 412 of the first layer 410 and the third ground conductor 432 of the third layer 430.

The second distance (T2), which is the distance between the first layer 410 and the third layer 430, may be larger than the first distance (T1), which is the distance between the first layer 410 and the second layer 420. That is, the third layer 430 may be further away from the first layer 410 than the second layer 420.

The fourth layer 440 of FIG. 5 and 6 is a layer disposed between the first layer 410 and the third layer 430. The flexible printed circuit board 401 may include one or a plurality (e.g., two) fourth layers 440. In various embodiments, a conductor for signal or power transmission may not be disposed in the fourth layer 440. In another embodiment, the fourth layer 440 may be a layer where the conductive wire 442 is disposed to transmit a different signal or power, and for example, the fourth layer 440 may be distinct from the RF conductive wire 412 of the first layer 410. In various embodiments, to minimize the generation of parasitic capacitance caused by the conductive wire 442 of the fourth layer 440, the conductive wire 442 may not be disposed in a region of the fourth layer that overlaps the RF conductive wire 412 of the first layer, based on the thickness direction (e.g., the z or -z direction) of the flexible printed circuit board 401.

In various embodiments, the first layer 410 and the fourth layer 440 and/or the fourth layer 440 and the third layer 430 may not be attached to each other. For example, an air gap 405 may be disposed in the region between the first layer 410 and the fourth layer 440 (this may be referred to as a "first region") and/or the region between the fourth layer 440 and the third layer 430 (this may be referred to as a "'second region"). In this document, the term 'air gap' refers to a gap between layers of the flexible printed circuit board(401) that are not bonded or attached to eachother. The air gap 405 serves to prevent the layers from becoming attached to each other or indeed needing to be attached to each other, thereby increasing the flexibility of the flexible printed circuit board 401. In addition, due to the absence of any adhesive layer, such as the adhesive layer 450, disposed between the first layer 410 and the third layer 430, the thickness of the flexible printed circuit board 401 may be reduced. In various embodiments, the thickness of the air gap 405 may vary within the electronic device, or be different as between one device and another.

Referring to FIG. 6, when a high frequency current (e.g., a radio frequency (RF) signal) is applied to the flexible printed circuit board 401, an electric field may be formed on the periphery of the RF conductive wire 412. The electric field may be generated by the parasitic capacitance formed by the RF conductive wire 412 and other conductors (e.g., the via 460, the second ground conductor 422, and the third ground conductor 432) positioned on the periphery of the RF conductive wire 412.

The electric field (E1) formed in the region located in the first direction of the RF conductive wire 412, that is, the region between the RF conductive wire 412 and the second ground conductor 422, may be stronger than the electric field (E2) formed in the second direction, that is, in the region between the RF conductive wire 412 and the third ground conductor 432. This is because the first distance (T1) is shorter than the second distance (T2). By positioning the second ground conductor 422 closer to the RF conductive wire 412 than the third ground conductor 432, the parasitic capacitance formed between the second ground conductor 422 and the RF conductive wire 412 may be greater than the parasitic capacitance formed between the third ground conductor 432 and the RF conductive wire 412. Therefore, the strength of the electric field formed around the RF conductive wire 412 may be relatively large in the region between the second ground conductor 422 and the RF conductive wire 412 and may be relatively weak in the region between the third ground conductor 432 and the RF conductive wire 412. That is, the electric field formed around the RF conductive wire 412 is concentrated in the first direction.

Due to the electric field around the RF wire 412, concentrated in the first direction, EMI generated by the RF wire 412 may also be concentrated in the first direction. Accordingly, relatively weak EMI may be experienced at the second direction of the RF conductive wire 412. Therefore, the third ground conductor 432 positioned in the second direction may sufficiently shield EMI generated by the RF conductive wire 412 even when not in contact to be electrically connected to the first layer 410 through a means such as the via 460. Since the third layer 430 and the first layer 410 do not need to be in contact through a structure such as a via to be electrically connected to each other, the adhesive layer 450 that adheres the layers from the third layer 430 to the first layer 410 may not be needed. Thus, the flexible printed circuit board 401 may have improved flexibility and reduced thickness, from omitting at least a part of the adhesive layer 450 of the flexible printed circuit board 401.

In addition, the effect of changes in parasitic capacitance on the overall impedance of the flexible printed circuit board 401, changes resulting from dimensional changes between the RF conductive wire 412 and the second ground conductor 422, may be reduced. Such a reduction results from the electric field around the RF conductive wire 412 being concentrated in the first direction.

The dimensions of the air gap 405 of the flexible printed circuit board 401 may vary due to assembly tolerances occurring when the flexible printed circuit board 401 is assembled into an electronic device, and/or changes in deformation and curvature of the flexible printed circuit board 401 may occur due to the folding operation of the electronic device when the electronic device is used. Since the above-mentioned dimensional variations change the parasitic capacitance of the flexible printed circuit board 401, the impedance of the flexible printed circuit board 401 may vary from the value configured through impedance matching at the time of initial design. The impedance variations may increase losses (e.g., insertion loss and/or return loss) in high frequency signals (e.g., radio frequency (RF) signals) passing through.

However, the parasitic capacitance between the third ground conductor 432 and the RF conductive wire 412 may be smaller than the parasitic capacitance between the second ground conductor 422 and the RF conductive wire 412. Thus, the effect on the overall impedance of the flexible printed circuit board 401 may be relatively small even though the parasitic capacitance between the third ground conductor 432 and the RF conductive wire 412 changes as the dimensions (primarily the thickness dimension) of the air gap 405 between the third ground conductor 432 and the RF conductive wire 412 change. Therefore, when a high-frequency signal is transmitted to the flexible printed circuit board 401 losses resulting from changes in the impedance of the flexible printed circuit board 401 may be reduced.

A conductor (e.g., a power wire or a signal wire) may in some examples not be disposed in the region of the fourth layer, overlapping the RF conductive wire 412 when viewed in the thickness direction of the flexible printed circuit board 401.

Referring to FIG. 7, the third ground conductor 432 of the third layer 430 may include a second mesh conductor 433. The second mesh conductor 433 may be a region of the third ground conductor 432 that is patterned to have a mesh shape. The second mesh conductor 433 may be disposed in a region that at least partially overlaps the RF conductive wire 412 of the first layer 410 in the vertical direction (e.g., the z-axis direction).

The area where the third ground conductor 432 and the RF conductive wire 412 overlap with each other may be reduced by patterning the region of the third ground conductor 432 that overlaps the RF conductive wire 412. Patterning may include forming a mesh, or similar shape or arrangement that is not continuous, or has gaps/spaces formed in the ground conductor 432. The parasitic capacitance formed between the third ground conductor 432 and the RF conductive wire 412 may be reduced due to the reduced overlapping area. By reducing the parasitic capacitance, the electric field formed around the RF conductive wire 412 may be concentrated in the first direction, and the effect of changes in the size of the air gap 405 on changes in impedance of the flexible printed circuit board 401 may be reduced.

The size, W, of the mesh pattern of the second mesh conductor 433 may be smaller than half the wavelength of the electromagnetic wave generated by the high-frequency signal transmitted to the RF conductive wire 412. Accordingly, EMI of the RF conductive wire 412 leaking into the empty region of the second mesh conductor 433 may be blocked and/or reduced.

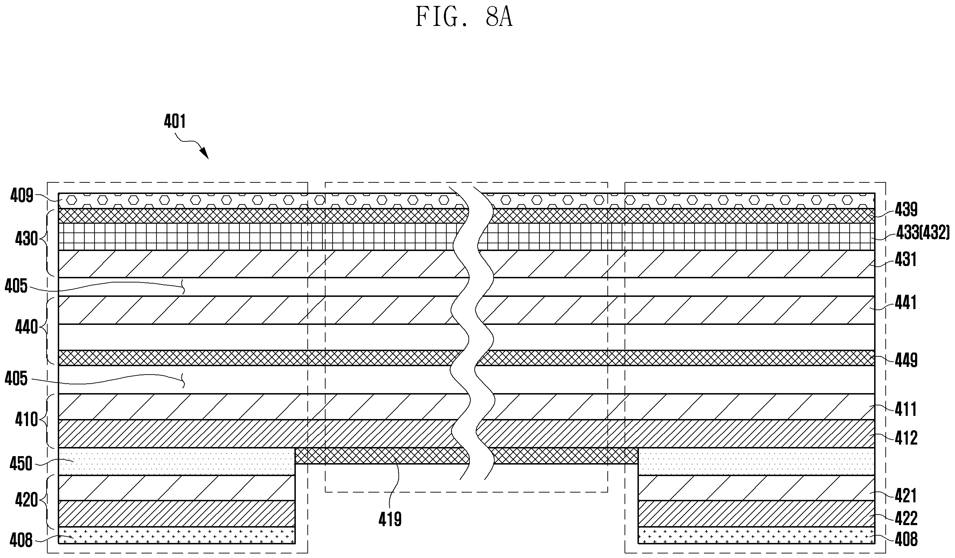

FIG. 8A is a cross-sectional view showing the flexible printed circuit board 401.

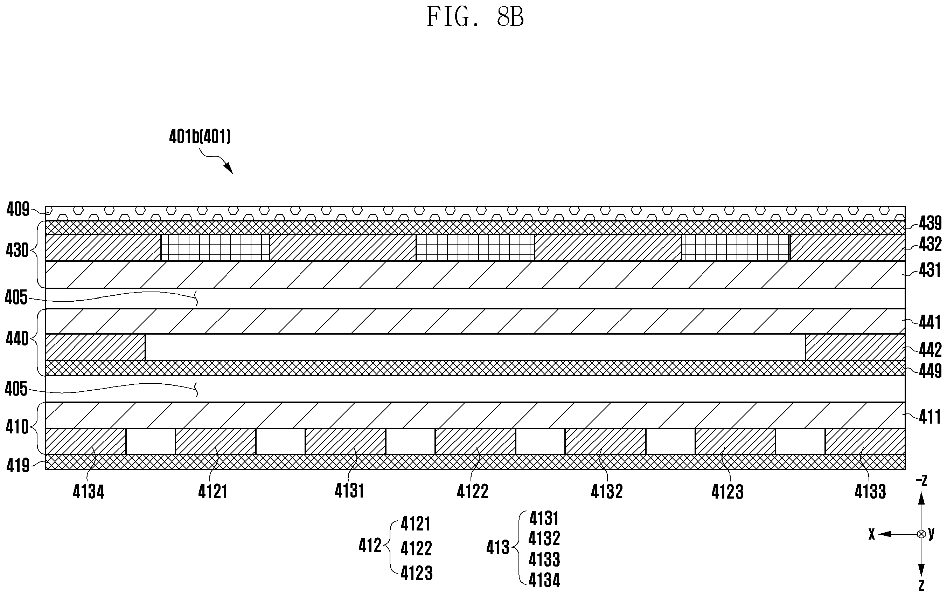

FIG. 8B is a cross-sectional view showing the second region 401b of the flexible printed circuit board 401.

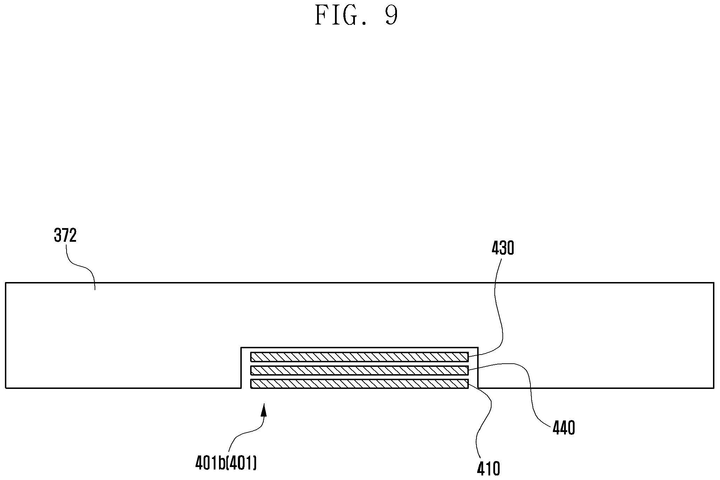

FIG. 9 is a schematic diagram showing the interior of an electronic device according to various embodiments.

FIG. 8A is a cross-sectional view taken along the line A-A' of FIG. 4B.

FIG. 8B is a cross-sectional view taken along line C-C' of FIG. 4B.

FIG. 9 is a cross-sectional view taken along line D-D' of FIG. 3.

Referring to FIGS. 8A and 8B, the flexible printed circuit board 401 may include the second region 401b having higher flexibility than the first region 401a. The rigidity of the second region (referred to as second rigidity) may have a higher value than the first rigidity of the first region. In various embodiments, the second region 401b may include layers extending from the first region 401a. For example, the first layer 410, the third layer 430, and at least one fourth layer 440 may extend from the first region 401a to the second region 401b. In various embodiments, the second region 401b may be positioned between the plurality of first regions 401a. For example, the plurality of first regions 401a may be positioned in the housing (e.g., the first housing 310 and the second housing 320 of FIG. 3) of the electronic device, and the second region may be positioned in a movable part of the electronic device (e.g., the folding region 300A of FIG. 3).

The second region 401b may be a region obtained by omitting some layers of the plurality of layers 410, 420, 430, and 440 of the flexible printed circuit board 401, to have higher flexibility compared to the first region 401a. For example, the second region 401b may include, with including the second layer 420, the first layer 410 having the RF conductive wire 412 disposed thereon, the third layer 430 having the third ground conductor 432 disposed thereon, and the fourth layer 440 positioned between the third layer 430 and the first layer 410. The flexibility of the second region 401b may be greater than that of the first region 401a by not including the second layer 420 and the adhesive layer 450 that adheres the first layer 410 to the second layer 420.

The first layer 410 of the second region 401b may include the RF conductive wire 412 and the first ground conductor 413. The first ground conductor 413 may be arranged alternately and in parallel with the RF conductive wires 412. The second region 401b may have a co-planar waveguide, "CPW", structure by alternately arranging the RF conductive wires 412 and the first ground conductors 413. Therefore, the electric field caused by the high-frequency current transmitted to the RF conductive wire 412 may be concentrated in a region between the RF conductive wire 412 and the first ground conductor 413, thereby reducing the EMI received by the RF conductive wire 412 from other surrounding electrical components (for example, the coil 372 of FIG. 3) and the EMI effecting by the RF conductive wire 412 to the periphery. The second region 401b may include the third layer 430 and the third ground conductor 432 disposed on the third layer 430, and thus the RF conductive wire 412 of the second region 401b may be shielded relatively well with respect to the second direction (e.g., the -z axis direction in the drawing) in which the third ground conductor 432 is disposed. In various embodiments, the first ground conductor 413 of the second region 401b may be electrically connected to the first ground conductor 413 of the first region 401a. For example, the first ground conductor 413 of the second region 401b may be formed by extending the first ground conductor 413 of the first region 401a to the second region 401b.

Referring to FIG. 9, among the electrical components of an electronic device, the second region 401b of the flexible printed circuit board 401 may be arranged to overlap an electrical component that generates EMI and/or are susceptible to EMI. For example, the second region 401b may be arranged to overlap the coil 372. The coil 372 may include, for example, a wireless charging coil and/or a near field communication, "NFC",) antenna.

The electrical component (e.g., coil 372) may be positioned in the second direction (e.g., the -z axis direction) relative to the flexible printed circuit board 401. For example, the flexible printed circuit board 401 may be disposed within the electronic device such that the third layer 430 faces the coil 372. Accordingly, EMI occurring between the RF conductive wire 412 and the electrical component (e.g., the coil 372) may be effectively shielded by the third ground conductor 432 of the third layer 430.

An electronic device according to the disclosure may include a housing and a flexible printed circuit board 401 positioned inside the housing and configured to transmit a radio frequency (RF) signal, wherein the flexible printed circuit board 401 may include a first layer 410 including a first ground conductor 413 and at least one RF conductive wire 412 for transmitting the radio frequency (RF) signal, a second layer 420 spaced apart from the first layer 410 by a first distance (T1) in a first direction perpendicular to one surface of the flexible printed circuit board 401 and including a second ground conductor 422, a third layer 430 spaced apart from the first layer 410 by a second distance (T2), which is longer than the first distance (T1), in a second direction opposite to the first direction and including a third ground conductor 432, and a fourth layer 440 positioned between the first layer 410 and the third layer 430.

In various embodiments, the fourth layer 440 may not be attached to at least one of the first layer 410 or the third layer 430.

In various embodiments, the at least one RF conductive wire 412 may include a first RF conductive wire 4121 and a second RF conductive wire 4122, wherein the first ground conductor 413 may include a first ground trace 4131 and a second ground trace 4132 that are alternately arranged in parallel with the first RF conductive wire 4121 and the second RF conductive wire 4122.

In various embodiments, the flexible printed circuit board 401 may include an adhesive layer 450 configured to bond the first layer 410 and the second layer 420 to each other, and one or more vias 460 penetrating the adhesive layer 450 and in contact with the second ground conductor 422, wherein at least one of the one or more vias 460 may be in contact with the first ground conductor 413.

In various embodiments, among the vias 460, at least one via in contact with the first ground conductor 413 may not be in contact with the third ground conductor 432.

In various embodiments, the second ground conductor 422 may include a first mesh conductor 426 disposed to at least partially overlap the at least one RF conductive wire 412 when viewed in the first direction, wherein the via 460 may not be in contact with the first mesh conductor 426.

In various embodiments, an air gap 405 may be disposed in at least one region among a first region between the first layer 410 and the fourth layer 440 or a second region between the fourth layer 440 and the third layer 430.

In various embodiments, the third ground conductor 432 may include a second mesh conductor 433 disposed to at least partially overlap the RF conductive wire 412 when viewed in the second direction.

In various embodiments, the flexible printed circuit board 401 may include a first region 401a having first rigidity in the longitudinal direction thereof and a second region 401b having second rigidity lower than the first rigidity, wherein each of the first layer 410, the third layer 430, and the fourth layer 440 may extend from the first region 401a to the second region 401b.

In various embodiments, the second layer 420 may be disposed only in at least a part of the first region 401a and may not be disposed in the second region 401b.

In various embodiments, the electronic device may further include an electrical component that generates electromagnetic interference (EMI), wherein the flexible printed circuit board 401 may be positioned in the first direction with respect to the electrical component, and the second region 401b may be positioned to at least partially overlap the electrical component when viewed in the first direction.

A flexible printed circuit board 401 according to various embodiments of the disclosure may include a first layer 410 including a first ground conductor 413 and at least one RF conductive wire 412 for transmitting a radio frequency (RF) signal, a second layer 420 spaced apart from the first layer 410 by a first distance (T1) in a first direction perpendicular to one surface of the flexible printed circuit board 401 and including a second ground conductor 422, a third layer 430 spaced apart from the first layer 410 by a second distance (T2), which is longer than the first distance (T1), in a second direction opposite to the first direction and including a third ground conductor 432, and a fourth layer 440 positioned between the first layer 410 and the third layer 430.

In various embodiments, the fourth layer 440 may not be attached to at least one of the first layer 410 or the third layer 430.

In various embodiments, the at least one RF conductive wire 412 may include a first RF conductive wire 4121 and a second RF conductive wire 4122, wherein the first ground conductor 413 may include a first ground trace 4131 and a second ground trace 4132 that are alternately arranged in parallel with the first RF conductive wire 4121 and the second RF conductive wire 4122.

In various embodiments, the flexible printed circuit board 401 may include an adhesive layer 450 configured to bond the first layer 410 and the second layer 420 to each other, and one or more vias 460 penetrating the adhesive layer 450 and in contact with the second ground conductor 422, wherein at least one of the one or more vias 460 may be in contact with the first ground conductor 413.

In various embodiments, among the vias 460, at least one via in contact with the first ground conductor 413 may not be in contact with the third ground conductor 432.

In various embodiments, the second ground conductor 422 may include a first mesh conductor 426 disposed to at least partially overlap the at least one RF conductive wire 412 when viewed in the first direction, wherein the via 460 may not be in contact with the first mesh conductor 426.

In various embodiments, an air gap 405 may be disposed in at least one region among a first region between the first layer 410 and the fourth layer 440 or a second region between the fourth layer 440 and the third layer 430.

In various embodiments, the third ground conductor 432 may include a second mesh conductor 433 disposed to at least partially overlap the RF conductive wire 412 when viewed in the second direction.

In various embodiments, the flexible printed circuit board 401 may include a first region 401a having first rigidity in the longitudinal direction thereof and a second region 401b having second rigidity lower than the first rigidity, wherein each of the first layer 410, the third layer 430, and the fourth layer 440 may extend from the first region 401a to the second region 401b.

In various embodiments, the second layer 420 may be disposed only in at least a part of the first region 401a and may not be disposed in the second region 401b.

The embodiments in the specification and drawings are merely presented as examples to explain the technical content in the disclosure, and to help understanding of the claimed embodiments.

## Claims

1. A flexible printed circuit board (401) comprising:
a first layer (410) comprising a first ground conductor (413) and at least one RF conductive wire (412) for transmitting a RF signal;
a second layer (420) spaced apart from the first layer (410) by a first distance (T1) in a first direction perpendicular to one surface of the flexible printed circuit board (401) and comprising a second ground conductor (422);
a third layer (430) spaced apart from the first layer (410) by a second distance (T2), which is longer than the first distance (T1), in a second direction opposite to the first direction and comprising a third ground conductor (432); and
a fourth layer (440) positioned between the first layer (410) and the third layer (430).

2. The flexible printed circuit board of claim 1, wherein the fourth layer (440) is not attached to at least one of the first layer (410) or the third layer (430).

3. The flexible printed circuit board of claim 1 or 2, wherein the at least one RF conductive wire (412) comprises a first RF conductive wire (4121) and a second RF conductive wire (4122), and
wherein the first ground conductor (413) comprises a first ground trace (4131) and a second ground trace (4132) that are alternately arranged in parallel with the first RF conductive wire (4121) and the second RF conductive wire (4122).

4. The flexible printed circuit board of any one of claims 1, 2 or 3, further comprising:
an adhesive layer (450) configured to attach the first layer (410) and the second layer (420) to each other; and
one or more vias (460) configured to penetrate the adhesive layer (450) and in contact with the second ground conductor (422), and
wherein at least one of the one or more vias (460) is in contact with the first ground conductor (413).

5. The flexible printed circuit board of claim 4, wherein, among the vias (460), at least one via in contact with the first ground conductor (413) is not in contact with the third ground conductor (432).

6. The flexible printed circuit board of claim 4 or 5, wherein the second ground conductor (422) comprises a first mesh conductor (426) disposed to at least partially overlap the at least one RF conductive wire (412) when viewed in the first direction, and
wherein the via (460) is not in contact with the first mesh conductor (426).

7. The flexible printed circuit board of any one of claims 1 to 6, wherein an air gap (405) is disposed in at least one region among a first region between the first layer (410) and the fourth layer (440) or a second region between the fourth layer (440) and the third layer (430).

8. The flexible printed circuit board of any one of claims 1 to 7, wherein the third ground conductor (432) comprises a second mesh conductor (433) disposed to at least partially overlap the RF conductive wire (412) when viewed in the second direction.

9. The flexible printed circuit board of any one of claims 1 to 8, further comprising:
a first region (401a) having first rigidity in the longitudinal direction thereof; and
a second region (401b) having second rigidity lower than the first rigidity, and
wherein each of the first layer (410), the third layer (430), and the fourth layer (440) extends from the first region (401a) to the second region (401b).

10. The flexible printed circuit board of claim 9, wherein the second layer (420) is disposed only in at least a part of the first region (401a) and is not disposed in the second region (401b).

11. An electronic device comprising:
a housing; and
the flexible printed circuit board (401) of any preceding claim positioned inside the housing, and configured to transmit a RF signal.

12. The electronic device of claim 11, further comprising an electrical component that generates electromagnetic interference ,
wherein the flexible printed circuit board (401) is positioned in the first direction with respect to the electrical component that generates electromagnetic interference, and
wherein the second region (401b) is positioned, when viewed in the first direction, to at least partially overlap the electrical component that generates electromagnetic interference.
